(19)

Europäisches
Patentamt

European
Patent Office

Office européen
des brevets

(11)　EP 2 947 264 A2

(12)　EUROPEAN PATENT APPLICATION

(43) Date of publication:
25.11.2015　Bulletin 2015/48

(51) Int Cl.:
*E21B 43/30* (2006.01)

(21) Application number: 15167831.5

(22) Date of filing: 15.05.2015

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA**

(30) Priority: **22.05.2014　US 201414285014**

(71) Applicants:
- **Services Petroliers Schlumberger**
  **75007 Paris (FR)**
  Designated Contracting States:
  **FR**
- **Logined B.V.**
  **2586 BJ S Gravenhage (NL)**
  Designated Contracting States:
  **AL AT BE BG CH CY CZ DE DK EE ES FI GB GR HR HU IE IT LI LT LU LV MC MK MT NL NO PL PT RO RS SE SI SK SM TR**
- **PRAD Research and Development Limited**
  **Road Town, Tortola 1110 (VG)**
  Designated Contracting States:
  **IS**

(72) Inventors:
- **Raphael, Scott Trevor**
  **Houston, TX Texas 77096 (US)**
- **Couet, Benoit**
  **Belmont, MA Massachusetts 02478 (US)**
- **Bailey, William J.**
  **Somerville, MA Massachusetts 02145 (US)**
- **Rashid, Kashif**
  **Wayland, MA Massachusetts 01778 (US)**
- **Tilke, Peter Gerhard**
  **Belmont, MA Massachusetts 02478 (US)**

(74) Representative: **Li, Boxi**
  **Schlumberger Cambridge Research Limited**
  **Intellectual Property Law**
  **High Cross**
  **Madingley Road**
  **Cambridge CB3 0EL (GB)**

(54)　**AUTOMATED SURFACE NETWORK GENERATION**

(57)　A method, apparatus, and program product automatically generate a surface network for an oilfield production system, e.g., as a new surface network or as an addition to an existing surface network. Candidate surface networks are generated from control vectors proposed by an optimization engine to optimize based upon an objective function that is based at least upon one or more geographical cost functions and one or more boundary conditions.

FIG. 16

## Description

BACKGROUND

Field development planning is used in the oil & gas industry to plan out the placement of prospective wells and other equipment in an oilfield. Field development planning may be used, for example, to select placements and trajectories for proposed wells into a subsurface reservoir to reach specific locations in the reservoir that are believed to contain recoverable hydrocarbons, and generally results in the development of a Field Development Plan (FDP). Determining optimum well placement, or even good well placement, however, is a complex problem. For example, the geology and geomechanics of subsurface conditions may influence both drilling cost and where wells can be reliably placed. Well trajectories may also need to avoid those of existing wells. Further, wells may have practical drilling and construction constraints, and constraints may also exist at the surface, including but not limited to bathymetric and topographic constraints, legal constraints, and constraints related to existing facilities such as platforms and pipelines. Furthermore, financial uncertainty may affect the viability of different solutions over time.

Automation efforts associated with field development planning have conventionally focused predominantly on well placement planning, i.e., the production of a Well Placement Plan (WPP) that includes one or more wells, as well as additional information such as well trajectories, well completions, drilling schedules, etc. Generally, a reservoir simulator is used in connection with well placement planning so that reservoir simulation may be performed to determine the potential value of any well placement plan.

However, other aspects of field development planning have generally required comparatively greater involvement by engineering personnel with less assistance from automated tools, thus increasing both costs and effort associated with developing a full FDP for an oilfield. One particular aspect is focused on the surface network in an oilfield, i.e., the facilities in an oilfield production system that are used to communicate fluids, including hydrocarbon assets output by producer wells, and in some instances, injection fluids for use by injection wells, between the wells in an oilfield and other components in a production facility. A surface network may be represented as a "graph", in which a collection of source, sink and/or manifold nodes (which may be referred to as "vertices" or "nodes" in graph terminology) are interconnected by conduits (which may be referred to as "edges" in graph terminology). Production networks are generally constrained by boundary conditions such as pressures, maximum flow rates, erosional velocities, fluid compositions, etc., as well as by additional physical constraints such as the sizes and/or types of conduits and other equipment in the network, the locations of natural obstacles such as rivers, and man-made obstacles, such as buildings and existing pipelines, etc.

As with the placement of wells, the design of a surface network can impact the efficacy and the profitability of a production system, so a continuing need exists for a more effective and computationally efficient approach for selecting an optimal surface network design, or for adding to an existing surface network.

SUMMARY

A method, apparatus, and program product automatically generate a surface network for an oilfield production system, e.g., as a new surface network or as an addition to an existing surface network. A control network, which includes a plurality of control variables over which to optimize, is generated. A candidate surface network is generated from the control vector, and a result is computed for an objective function for the candidate surface network. The result is computed for the objective function based upon a geographical cost function and a boundary condition.

These and other advantages and features, which characterize the invention, are set forth in the claims annexed hereto and forming a further part hereof. However, for a better understanding of the invention, and of the advantages and objectives attained through its use, reference should be made to the Drawings, and to the accompanying descriptive matter, in which there is described example embodiments of the invention. This summary is merely provided to introduce a selection of concepts that are further described below in the detailed description, and is not intended to identify key or essential features of the claimed subject matter, nor is it intended to be used as an aid in limiting the scope of the claimed subject matter.

BRIEF DESCRIPTION OF THE DRAWINGS

FIGURE 1 is a block diagram of an example hardware and software environment for a data processing system in accordance with implementation of various technologies and techniques described herein.

FIGURES 2A-2D illustrate simplified, schematic views of an oilfield having subterranean formations containing reservoirs therein in accordance with implementations of various technologies and techniques described herein.

FIGURE 3 illustrates a schematic view, partially in cross section of an oilfield having a plurality of data acquisition tools positioned at various locations along the oilfield for collecting data from the subterranean formations in accordance with implementations of various technologies and techniques described herein.

FIGURE 4 illustrates a production system for performing one or more oilfield operations in accordance with implementations of various technologies and techniques described herein.

FIGURE 5 illustrates a node topology map for an example geographical area and implementing a node geographical cost function in accordance with implementations of various technologies and techniques described herein.

FIGURE 6 illustrates an edges topology map for the example geographical area of Fig. 5 and implementing an edges geographical cost function in accordance with implementations of various technologies and techniques described herein.

FIGURE 7 illustrates an example existing surface network and associated properties superimposed on the node topology map of Fig. 5.

FIGURE 8 illustrates the use of automated surface network generation in accordance with implementations of various technologies and techniques described herein to connect a new node at a known location to a known manifold node in the existing surface network of Fig. 7.

FIGURE 9 illustrates the use of automated surface network generation in accordance with implementations of various technologies and techniques described herein to connect a new node at a location in a vicinity to a known manifold node in the existing surface network of Fig. 7.

FIGURE 10 illustrates the use of automated surface network generation in accordance with implementations of various technologies and techniques described herein to connect a new node at a known location to an unknown manifold node in the existing surface network of Fig. 7.

FIGURE 11 illustrates the use of automated surface network generation in accordance with implementations of various technologies and techniques described herein to connect a new node at a location in a vicinity to an unknown manifold node in the existing surface network of Fig. 7.

FIGURE 12 illustrates the use of automated surface network generation in accordance with implementations of various technologies and techniques described herein to connect multiple new nodes at locations in multiple vicinities to unknown manifold nodes in the existing surface network of Fig. 7.

FIGURE 13 illustrates the use of automated surface network generation in accordance with implementations of various technologies and techniques described herein, and illustrating clustering nodes within a boundary in the existing surface network of Fig. 7.

FIGURE 14 illustrates the use of automated surface network generation in accordance with implementations of various technologies and techniques described herein to connect a new node at a known location to a new manifold node in the existing surface network of Fig. 7.

FIGURE 15 illustrates the use of automated surface network generation in accordance with implementations of various technologies and techniques described herein to add a new manifold node to the existing surface network of Fig. 7, and illustrating iterative optimization of the surface network thereafter.

FIGURE 16 is a flow chart illustrating one embodiment of a method of generating a surface network for a well placement plan.

DETAILED DESCRIPTION

The herein-described embodiments provide a method, apparatus, and program product that automatically generate a surface network for an oilfield production system. Candidate surface networks may be generated from control vectors proposed by an optimization engine to optimize based upon an objective function that is based at least upon one or more geographical cost functions and one or more boundary conditions.

A geographical cost function, within the context of the invention, may include any function that maps or otherwise outputs a cost based at least in part upon a location-based parameter. In some of the embodiments below, for example, a geographical cost function may include a node topology map or an edges topology map. A node topology map, for example, may be used to map a cost to topological coordinates (e.g., in two or three dimensions) for a proposed node in a surface network, while an edges topology map may be used to map a cost to topological coordinates, distances and/or orientation (e.g., azimuth) for a proposed edge in a surface network. The cost for such functions may be in terms of a particular currency, although it will be appreciated by those of ordinary skill that cost may also incorporated non-currency aspects as well, e.g., based in terms of labor, materials, or another indicator of the relative ease or difficulty of implementing a node at a particular location and/or an edge along a particular trajectory.

A boundary condition, within the context of the invention, may include any condition that constrains the development of a surface network, including geographical or location-based constraints such as natural or man-made obstructions or topological features, legal constraints, constraints related to an existing surface network or production system, etc.

Embodiments consistent with the invention may be used, for example, to provide automatic and optimal extension of an existing surface network to accommodate new source and sink nodes, e.g., wells (injectors and/or producers), and manifold nodes that are connected by edges (generally pipes, tubulars, conduits, etc.). Other embodiments may support the initial generation of a surface network, so the invention is not limited solely to the extension of an existing surface network. However, the embodiments discussed hereinafter will generally focus on the particular application of adding to or otherwise extending an existing surface network.

In particular, embodiments consistent with the invention may programmatically link one or more new nodes to an existing surface network, e.g., to manifold node(s), gathering node(s), facility node(s), equipment node(s) and/or tie-back point(s). This may also include connecting node(s) to each other via conduits (e.g., simple pipes, ducts or conduits including large export trunk lines), which may also be referred to herein as an "edges". The programmatic linking may be performed with a goal of optimizing, e.g., minimizing or maximizing, some stated figure-of-merit (FOM), which is generally based upon some objective function, in the design and development of surface network(s). The figure-of-merit being considered may involve minimization of some cost, the maximization of some monetary return (e.g., Net Present Value, NPV) or any other suitable quantity, e.g., some composite function involving capital and operating cost or fluid production and injection.

In some embodiments, a surface network is generated in connection with the generation of a well placement plan. In this regard, a well placement plan, also referred to as a field development plan, may be considered to include, in addition to a surface network, one or more wells proposed for a geographic region such as an oil field, as well as additional planning information associated with drilling and completing the wells, including, for example, location and/or trajectory information, completion information, drilling schedule information, projected production information, or any other information suitable for use in drilling the proposed wells.

Also, in some embodiments, a well placement plan, including a surface network, may be generated using a constrained optimization framework and may be based at least in part on a reservoir model. Candidate well placement plans and associated surface networks may be generated from control vectors proposed by an optimization engine to optimize based upon an objective function. A constrained optimization framework may be considered to include a framework through which a constrained optimization approach may be applied to the generation of a well placement plan (WPP) and/or surface network in the presence of uncertainty and risk, based upon one or more reservoir models, and based upon a set of constraints that drive the feasibility of candidate well placement plans and/or surface networks developed by the framework. Constraints may be geometric, operational, contractual and/or legal in nature, and one or more reservoir simulators may be used in some embodiments to compute an objective function that drives the optimization to a desired end result, e.g., to maximize net present value, return on investment, profitability, production, etc., and well placement plans and/or surface networks are associated with control vectors that are used to calculate the objective function for different well placement plans and/or surface networks.

Other variations and modifications will be apparent to one of ordinary skill in the art.

Hardware and Software Environment

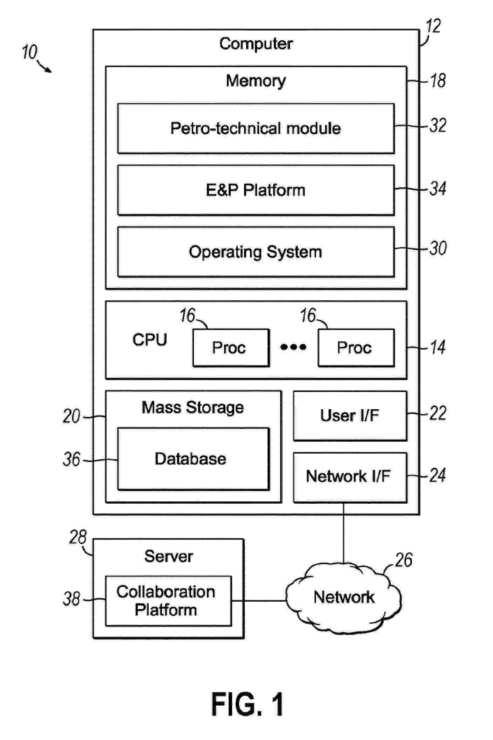

Turning now to the drawings, wherein like numbers denote like parts throughout the several views, Fig. 1 illustrates an example data processing system 10 in which the various technologies and techniques described herein may be implemented. System 10 is illustrated as including one or more computers 12, e.g., client computers, each including a central processing unit (CPU) 14 including at least one hardware-based processor or processing core 16. CPU 14 is coupled to a memory 18, which may represent the random access memory (RAM) devices comprising the main storage of a computer 12, as well as any supplemental levels of memory, e.g., cache memories, non-volatile or backup memories (e.g., programmable or flash memories), read-only memories, etc. In addition, memory 18 may be considered to include memory storage physically located elsewhere in a computer 12, e.g., any cache memory in a microprocessor or processing core, as well as any storage capacity used as a virtual memory, e.g., as stored on a mass storage device 20 or on another computer coupled to a computer 12.

Each computer 12 also generally receives a number of inputs and outputs for communicating information externally. For interface with a user or operator, a computer 12 generally includes a user interface 22 incorporating one or more user input/output devices, e.g., a keyboard, a pointing device, a display, a printer, etc. Otherwise, user input may be received, e.g., over a network interface 24 coupled to a network 26, from one or more external computers, e.g., one or more servers 28 or other computers 12. A computer 12 also may be in communication with one or more mass storage devices 20, which may be, for example, internal hard disk storage devices, external hard disk storage devices, storage area network devices, etc.

A computer 12 generally operates under the control of an operating system 30 and executes or otherwise relies upon various computer software applications, components, programs, objects, modules, data structures, etc. For example, a petro-technical module or component 32 executing within an exploration and production (E&P) platform 34 may be used to access, process, generate, modify or otherwise utilize petro-technical data, e.g., as stored locally in a database 36 and/or accessible remotely from a collaboration platform 38. Collaboration platform 38 may be implemented using multiple servers 28 in some implementations, and it will be appreciated that each server 28 may incorporate a CPU, memory, and other hardware components similar to a computer 12.

In one non-limiting embodiment, for example, E&P platform 34 may implemented as the PETREL Exploration & Production (E&P) software platform, while collaboration platform 38 may be implemented as the STUDIO E&P KNOWLEDGE ENVIRONMENT platform, both of which are available from Schlumberger Ltd. and its affiliates. It will be appreciated, however, that the techniques discussed herein may be utilized in connection with other platforms and environments, so the invention is not limited to the particular software platforms and environments discussed herein.

In general, the routines executed to implement the embodiments disclosed herein, whether implemented as part of an operating system or a specific application, component, program, object, module or sequence of instructions, or even a subset thereof, will be referred to herein as "computer program code," or simply "program code." Program code generally comprises one or more instructions that are resident at various times in various memory and storage devices in a computer, and that, when read and executed by one or more hardware-based processing units in a computer (e.g., microprocessors, processing cores, or other hardware-based circuit logic), cause that computer to perform the steps embodying desired functionality. Moreover, while embodiments have and hereinafter will be described in the context of fully functioning computers and computer systems, those skilled in the art will appreciate that the various embodiments are capable of being distributed as a program product in a variety of forms, and that the invention applies equally regardless of the particular type of computer readable media used to actually carry out the distribution.

Such computer readable media may include computer readable storage media and communication media. Computer readable storage media is non-transitory in nature, and may include volatile and non-volatile, and removable and non-removable media implemented in any method or technology for storage of information, such as computer-readable instructions, data structures, program modules or other data. Computer readable storage media may further include RAM, ROM, erasable programmable read-only memory (EPROM), electrically erasable programmable read-only memory (EEPROM), flash memory or other solid state memory technology, CD-ROM, DVD, or other optical storage, magnetic cassettes, magnetic tape, magnetic disk storage or other magnetic storage devices, or any other medium that can be used to store the desired information and which can be accessed by computer 10. Communication media may embody computer readable instructions, data structures or other program modules. By way of example, and not limitation, communication media may include wired media such as a wired network or direct-wired connection, and wireless media such as acoustic, RF, infrared and other wireless media. Combinations of any of the above may also be included within the scope of computer readable media.

Various program code described hereinafter may be identified based upon the application within which it is implemented in a specific embodiment of the invention. However, it should be appreciated that any particular program nomenclature that follows is used merely for convenience, and thus the invention should not be limited to use solely in any specific application identified and/or implied by such nomenclature. Furthermore, given the endless number of manners in which computer programs may be organized into routines, procedures, methods, modules, objects, and the like, as well as the various manners in which program functionality may be allocated among various software layers that are resident within a typical computer (e.g., operating systems, libraries, API's, applications, applets, etc.), it should be appreciated that the invention is not limited to the specific organization and allocation of program functionality described herein.

Furthermore, it will be appreciated by those of ordinary skill in the art having the benefit of the instant disclosure that the various operations described herein that may be performed by any program code, or performed in any routines, workflows, or the like, may be combined, split, reordered, omitted, and/or supplemented with other techniques known in the art, and therefore, the invention is not limited to the particular sequences of operations described herein.

Those skilled in the art will recognize that the example environment illustrated in Fig. 1 is not intended to limit the invention. Indeed, those skilled in the art will recognize that other alternative hardware and/or software environments may be used without departing from the scope of the invention.

Oilfield Operations

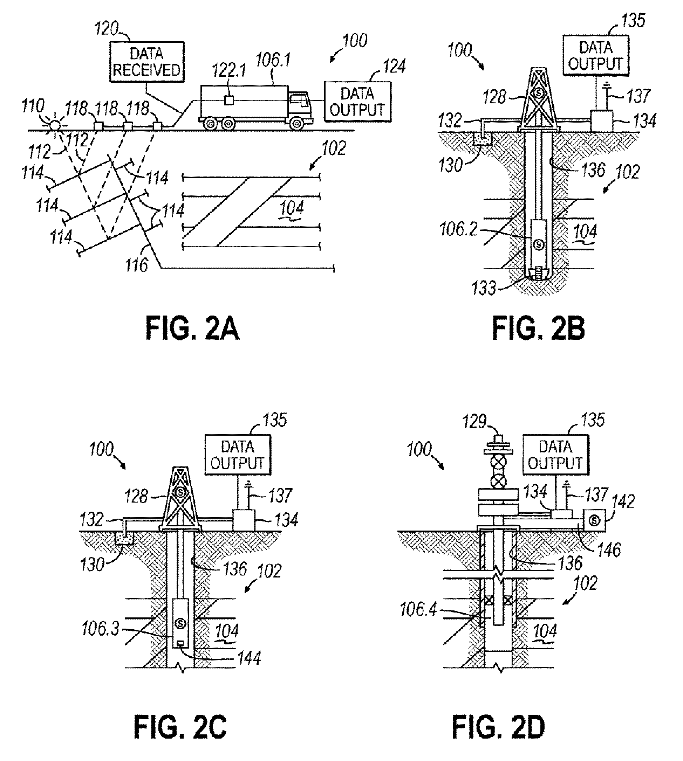

Figs. 2A-2D illustrate simplified, schematic views of an oilfield 100 having subterranean formation 102 containing reservoir 104 therein in accordance with implementations of various technologies and techniques described herein. Fig. 2A illustrates a survey operation being performed by a survey tool, such as seismic truck 106.1, to measure properties of the subterranean formation. The survey operation is a seismic survey operation for producing sound vibrations. In Fig. 2A, one such sound vibration, sound vibration 112 generated by source 110, reflects off horizons 114 in earth formation 116. A set of sound vibrations is received by sensors, such as geophone-receivers 118, situated on the earth's surface. The data received 120 is provided as input data to a computer 122.1 of a seismic truck 106.1, and responsive to the input data, computer 122.1 generates seismic data output 124. This seismic data output may be stored, transmitted or further processed as desired, for example, by data reduction.

Fig. 2B illustrates a drilling operation being performed by drilling tools 106.2 suspended by rig 128 and advanced into subterranean formations 102 to form wellbore 136. Mud pit 130 is used to draw drilling mud into the drilling tools via flow line 132 for circulating drilling mud down through the drilling tools, then up wellbore 136 and back to the surface. The drilling mud may be filtered and returned to the mud pit. A circulating system may be used for storing, controlling, or filtering the flowing drilling muds. The drilling tools are advanced into subterranean formations 102 to reach reservoir 104. Each well may target one or more reservoirs. The drilling tools are adapted for measuring downhole properties using logging while drilling tools. The logging while drilling tools may also be adapted for taking core sample 133 as shown.

Computer facilities may be positioned at various locations about the oilfield 100 (e.g., the surface unit 134) and/or at remote locations. Surface unit 134 may be used to communicate with the drilling tools and/or offsite operations, as well as with other surface or downhole sensors. Surface unit 134 is capable of communicating with the drilling tools to send commands to the drilling tools, and to receive data therefrom. Surface unit 134 may also collect data generated during the drilling operation and produces data output 135, which may then be stored or transmitted.

Sensors (S), such as gauges, may be positioned about oilfield 100 to collect data relating to various oilfield operations as described previously. As shown, sensor (S) is positioned in one or more locations in the drilling tools and/or at rig 128 to measure drilling parameters, such as weight on bit, torque on bit, pressures, temperatures, flow rates, compositions, rotary speed, and/or other parameters of the field operation. Sensors (S) may also be positioned in one or more locations in the circulating system.

Drilling tools 106.2 may include a bottom hole assembly (BHA) (not shown), generally referenced, near the drill bit (e.g., within several drill collar lengths from the drill bit). The bottom hole assembly includes capabilities for measuring, processing, and storing information, as well as communicating with surface unit 134. The bottom hole assembly further includes drill collars for performing various other measurement functions.

The bottom hole assembly may include a communication subassembly that communicates with surface unit 134. The communication subassembly is adapted to send signals to and receive signals from the surface using a communications channel such as mud pulse telemetry, electro-magnetic telemetry, or wired drill pipe communications. The communication subassembly may include, for example, a transmitter that generates a signal, such as an acoustic or electromagnetic signal, which is representative of the measured drilling parameters. It will be appreciated by one of skill in the art that a variety of telemetry systems may be employed, such as wired drill pipe, electromagnetic or other known telemetry systems.

Generally, the wellbore is drilled according to a drilling plan that is established prior to drilling. The drilling plan sets forth equipment, pressures, trajectories and/or other parameters that define the drilling process for the wellsite. The drilling operation may then be performed according to the drilling plan. However, as information is gathered, the drilling operation may need to deviate from the drilling plan. Additionally, as drilling or other operations are performed, the subsurface conditions may change. The earth model may also need adjustment as new information is collected.

The data gathered by sensors (S) may be collected by surface unit 134 and/or other data collection sources for analysis or other processing. The data collected by sensors (S) may be used alone or in combination with other data. The data may be collected in one or more databases and/or transmitted on or offsite. The data may be historical data, real time data, or combinations thereof. The real time data may be used in real time, or stored for later use. The data may also be combined with historical data or other inputs for further analysis. The data may be stored in separate databases, or combined into a single database.

Surface unit 134 may include transceiver 137 to allow communications between surface unit 134 and various portions of the oilfield 100 or other locations. Surface unit 134 may also be provided with or functionally connected to one or more controllers (not shown) for actuating mechanisms at oilfield 100. Surface unit 134 may then send command signals to oilfield 100 in response to data received. Surface unit 134 may receive commands via transceiver 137 or may itself execute commands to the controller. A processor may be provided to analyze the data (locally or remotely), make the decisions and/or actuate the controller. In this manner, oilfield 100 may be selectively adjusted based on the data collected. This technique may be used to optimize portions of the field operation, such as controlling drilling, weight on bit, pump rates, or other parameters. These adjustments may be made automatically based on computer protocol, and/or manually by an operator. In some cases, well plans may be adjusted to select optimum operating conditions, or to avoid problems.

Fig. 2C illustrates a wireline operation being performed by wireline tool 106.3 suspended by rig 128 and into wellbore 136 of Fig. 2B. Wireline tool 106.3 is adapted for deployment into wellbore 136 for generating well logs, performing downhole tests and/or collecting samples. Wireline tool 106.3 may be used to provide another method and apparatus for performing a seismic survey operation. Wireline tool 106.3 may, for example, have an explosive, radioactive, electrical, or acoustic energy source 144 that sends and/or receives electrical signals to surrounding subterranean formations 102 and fluids therein.

Wireline tool 106.3 may be operatively connected to, for example, geophones 118 and a computer 122.1 of a seismic truck 106.1 of Fig. 2A. Wireline tool 106.3 may also provide data to surface unit 134. Surface unit 134 may collect data generated during the wireline operation and may produce data output 135 that may be stored or transmitted. Wireline tool 106.3 may be positioned at various depths in the wellbore 136 to provide a survey or other information relating to the subterranean formation 102.

Sensors (S), such as gauges, may be positioned about oilfield 100 to collect data relating to various field operations as described previously. As shown, sensor S is positioned in wireline tool 106.3 to measure downhole parameters which relate to, for example porosity, permeability, fluid composition and/or other parameters of the field operation.

Fig. 2D illustrates a production operation being performed by production tool 106.4 deployed from a production unit or Christmas tree 129 and into completed wellbore 136 for drawing fluid from the downhole reservoirs into surface facilities 142. The fluid flows from reservoir 104 through perforations in the casing (not shown) and into production tool 106.4 in wellbore 136 and to surface facilities 142 via gathering network 146.

Sensors (S), such as gauges, may be positioned about oilfield 100 to collect data relating to various field operations as described previously. As shown, the sensor (S) may be positioned in production tool 106.4 or associated equipment, such as christmas tree 129, gathering network 146, surface facility 142, and/or the production facility, to measure fluid parameters, such as fluid composition, flow rates, pressures, temperatures, and/or other parameters of the production operation.

Production may also include injection wells for added recovery. One or more gathering facilities may be operatively connected to one or more of the wellsites for selectively collecting downhole fluids from the wellsite(s).

While Figs. 2B-2D illustrate tools used to measure properties of an oilfield, it will be appreciated that the tools may be used in connection with non-oilfield operations, such as gas fields, mines, aquifers, storage, or other subterranean facilities. Also, while certain data acquisition tools are depicted, it will be appreciated that various measurement tools capable of sensing parameters, such as seismic two-way travel time, density, resistivity, production rate, etc., of the subterranean formation and/or its geological formations may be used. Various sensors (S) may be located at various positions along the wellbore and/or the monitoring tools to collect and/or monitor the desired data. Other sources of data may also be provided from offsite locations.

The field configurations of Figs. 2A-2D are intended to provide a brief description of an example of a field usable with oilfield application frameworks. Part, or all, of oilfield 100 may be on land, water, and/or sea. Also, while a single field measured at a single location is depicted, oilfield applications may be utilized with any combination of one or more oilfields, one or more processing facilities and one or more wellsites.

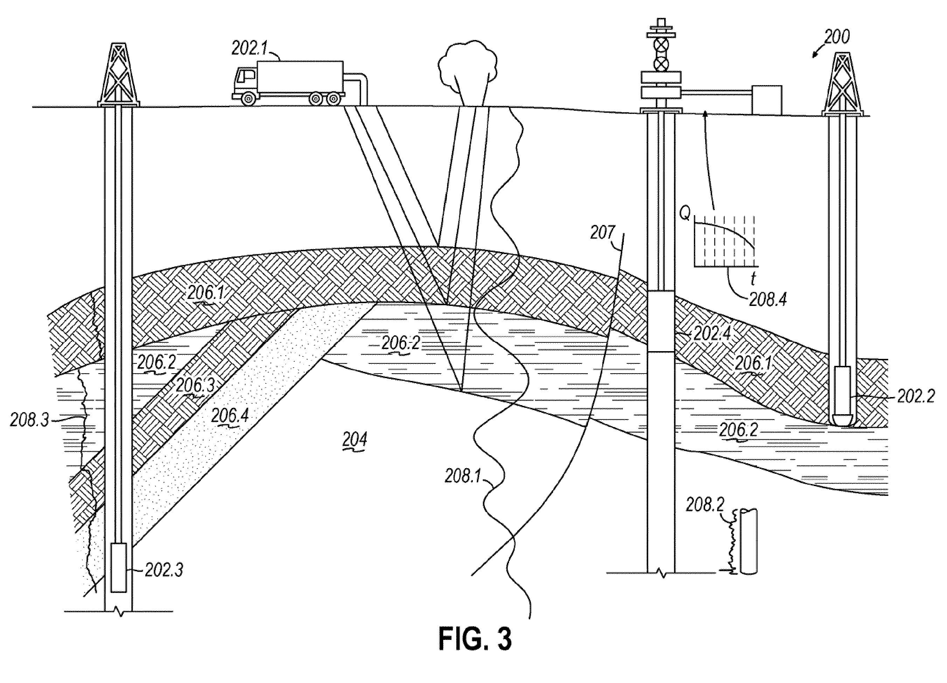

Fig. 3 illustrates a schematic view, partially in cross section of oilfield 200 having data acquisition tools 202.1, 202.2, 202.3 and 202.4 positioned at various locations along oilfield 200 for collecting data of subterranean formation 204 in accordance with implementations of various technologies and techniques described herein. Data acquisition tools 202.1-202.4 may be the same as data acquisition tools 106.1-106.4 of Figs. 2A-2D, respectively, or others not depicted. As shown, data acquisition tools 202.1-202.4 generate data plots or measurements 208.1-208.4, respectively. These data plots are depicted along oilfield 200 to demonstrate the data generated by the various operations.

Data plots 208.1-208.3 are examples of static data plots that may be generated by data acquisition tools 202.1-202.3, respectively, however, it should be understood that data plots 208.1-208.3 may also be data plots that are updated in real time. These measurements may be analyzed to better define the properties of the formation(s) and/or determine the accuracy of the measurements and/or for checking for errors. The plots of each of the respective measurements may be aligned and scaled for comparison and verification of the properties.

Static data plot 208.1 is a seismic two-way response over a period of time. Static plot 208.2 is core sample data measured from a core sample of the formation 204. The core sample may be used to provide data, such as a graph of the density, porosity, permeability, or some other physical property of the core sample over the length of the core. Tests for density and viscosity may be performed on the fluids in the core at varying pressures and temperatures. Static data plot 208.3 is a logging trace that generally provides a resistivity or other measurement of the formation at various depths.

A production decline curve or graph 208.4 is a dynamic data plot of the fluid flow rate over time. The production decline curve generally provides the production rate as a function of time. As the fluid flows through the wellbore, measurements are taken of fluid properties, such as flow rates, pressures, composition, etc.

Other data may also be collected, such as historical data, user inputs, economic information, and/or other measurement data and other parameters of interest. As described below, the static and dynamic measurements may be analyzed and used to generate models of the subterranean formation to determine characteristics thereof. Similar measurements may also be used to measure changes in formation aspects over time.

The subterranean structure 204 has a plurality of geological formations 206.1-206.4. As shown, this structure has several formations or layers, including a shale layer 206.1, a carbonate layer 206.2, a shale layer 206.3 and a sand layer 206.4. A fault 207 extends through the shale layer 206.1 and the carbonate layer 206.2. The static data acquisition tools are adapted to take measurements and detect characteristics of the formations.

While a specific subterranean formation with specific geological structures is depicted, it will be appreciated that oilfield 200 may contain a variety of geological structures and/or formations, sometimes having extreme complexity. In some locations, generally below the water line, fluid may occupy pore spaces of the formations. Each of the measurement devices may be used to measure properties of the formations and/or its geological features. While each acquisition tool is shown as being in specific locations in oilfield 200, it will be appreciated that one or more types of measurement may be taken at one or more locations across one or more fields or other locations for comparison and/or analysis.

The data collected from various sources, such as the data acquisition tools of Fig. 3, may then be processed and/or evaluated. Generally, seismic data displayed in static data plot 208.1 from data acquisition tool 202.1 is used by a geophysicist to determine characteristics of the subterranean formations and features. The core data shown in static plot 208.2 and/or log data from well log 208.3 are generally used by a geologist to determine various characteristics of the subterranean formation. The production data from graph 208.4 is generally used by the reservoir engineer to determine fluid flow reservoir characteristics. The data analyzed by the geologist, geophysicist and the reservoir engineer may be analyzed using modeling techniques.

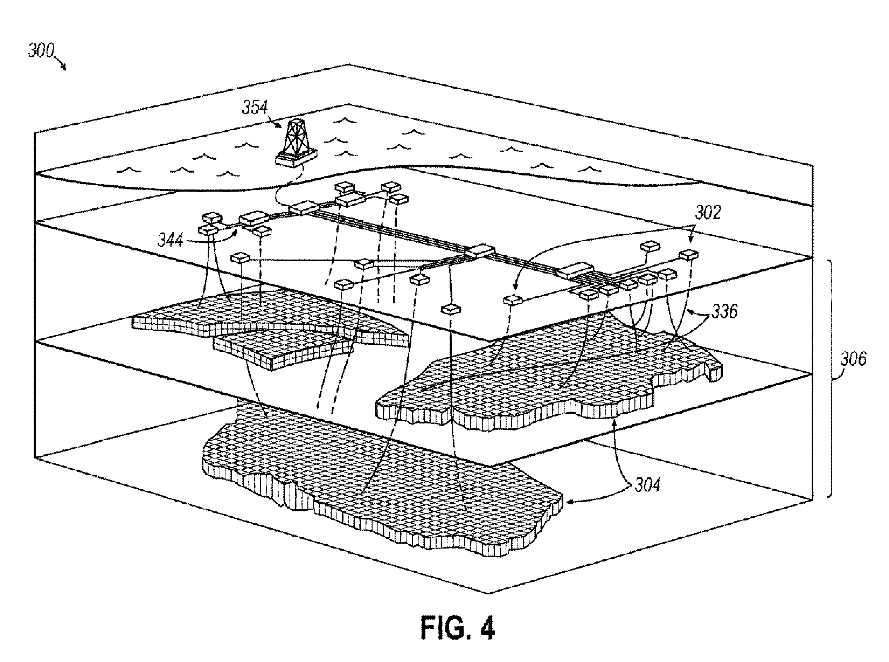

Fig. 4 illustrates an oilfield 300 for performing production operations in accordance with implementations of various technologies and techniques described herein. As shown, the oilfield has a plurality of wellsites 302 operatively connected to central processing facility 354. The oilfield configuration of Fig. 4 is not intended to limit the scope of the oilfield application system. Part or all of the oilfield may be on land and/or sea. Also, while a single oilfield with a single processing facility and a plurality of wellsites is depicted, any combination of one or more oilfields, one or more processing facilities and one or more wellsites may be present.

Each wellsite 302 has equipment that forms wellbore 336 into the earth. The wellbores extend through subterranean formations 306 including reservoirs 304. These reservoirs 304 contain fluids, such as hydrocarbons. The wellsites draw fluid from the reservoirs and pass them to the processing facilities via surface networks 344. The surface networks 344 have tubing and control mechanisms for controlling the flow of fluids from the wellsite to processing facility 354.

Automated Surface Network Generation

Embodiments consistent with the invention provide for an automated generation of a surface network design mechanism. The "network" referred to herein may comprise a single sink/source/manifold node and associated conduit(s) (referred to as "edges") that are tied back to an existing network, or may comprise a full-field gathering network with, or without, a suitable tie-back point. That is, in some embodiments, any number of new nodes (sources/sinks) may be accommodated by the appropriate selection of edges (pathways, typically a pipe or conduit or duct) to existing manifold nodes such that an objective function, representing a figure-of-merit (FOM), is maximized or minimized, as may be appropriate for the particular FOM. Note that the term "manifold node" may, in some embodiments, refer to multiple manifolds, including gathering points, equipment, facilities (individual units or a system of such), tie-back points or any collection node.

Within the context of the disclosure, a surface network may be generally defined by boundary conditions imposed on the nodes and edges, generally as pressures, maximum flow rates, erosional velocities, etc., or some combination thereof. Fluid composition (generally from producer wells, and in some embodiments, from injector wells) may be an additional consideration, particularly for flow assurance issues, which in some embodiments may be useful for the prevention of hydrates, waxes and asphaltenes, etc., which may block (or choke) a free flow of fluids through a network. In addition, the topology of the network, e.g., including the definition of sizes and/or equipment in each branch (generally, an edge with one or more nodes) may also be defined, and may be guided and/or constrained by surface maps, as well as physical constraints (e.g., natural obstacles such as rivers, and man-made obstacles, such as buildings and existing pipelines). Once these elements have been defined, a network model may be solved to ascertain unknown quantities in the model (e.g., pressures and flow rates) throughout the network/gathering system. Embodiments consistent with the invention, may be used to optimize the design (e.g., topology, configuration, etc.) of the network(s) against a FOM or objective function, e.g., to maximize NPV, minimize operational cost, etc., subject to operational, handling capacity and/or other constraints that may be present in the system.

By way of example, the following discussion is focused upon an objective function or FOM based on NPV, expressed in dollar terms. Thus, any new network configuration may be selected so as to maximize this metric subject to the various constraints established for the network. This objective function, however, is not the exclusive objective function that may be used, so the invention is not limited to optimization focused on maximizing NPV.

Nodes and Edges

For the purposes of the invention, a surface network system may be considered to be represented by a collection of nodes that are connected by conduits, also referred to as edges. Other equipment utilized to support flow may also be considered. For any hydrocarbon asset (or $CO_2$ injection system), such a network may include three primary node types, including:

Source node -a source of a fluid stream, e.g., a producer well.

Sink node - a sink for fluid to flow into, e.g., an injector well.

Manifold node - a node where one, or more, connection edges gather.

Each node is connected by one or more edges (denoted as $\alpha$), which enable flow from one node (in x-y space) to another node (in x-y space). A combination of nodes and edges may be used to deploy various optimization techniques and methods (e.g., graph theory) to establish a value for an objective function, F, representing a figure-of-merit, thereby enabling the optimization of a surface network.

A network may be considered to be defined by nodes connected together by edges. For example, the outlet of an edge $\alpha_{i-1}$ (downstream) may be connected (via a node) to a next edge upstream, $\alpha_i$. Each edge may also be considered to possess one or more of the following characteristics: an inlet pressure, an outlet pressure, a uniform cross-sectional area (generally circular although non-circular ducts/conduits may exist), an internal roughness (perfectly smooth pipes/conduits may have zero roughness), a maximum flowing capacity (generally limited by an erosional velocity), a non-zero length (although edges may have different lengths and/or geometries. In addition, as with a node, an edge may also include equipment, such as a compressor, splitter, joint, etc. Nodes and edges may be connected to other nodes and edges, both new and existing, to form a network or series of networks, and edges may be cut and intersected into ("tied-in" or "tied-back") by another edge by adding a suitable node at the desired location or locations.

As such, in the embodiments discussed herein a network forthcoming from an optimization may be made up of a multitude and combination of nodes and edges to form a desired network design. Pumps, boosters, compressors and heaters may also be present in a network, and may be incorporated into edges and/or nodes. Irrespective of the nature of such devices, so long they are defined (and costed) within a node or edge, their presence may be accounted for during generation and evaluation of an objective function.

By defining a network in terms of nodes and edges, a modular framework (structure) may be applied for the purposes of optimization. As such, in some embodiments, an optimized surface network (be it new (green-field), tied into an existing network (brown-field) or connecting to some in-fill region (a combination of both green- and brown-field)), may be constructed using only a combination of nodes and edges.

It will be appreciated that other surface facilities may be a constraining factor due to storage and capacity handling limits that arise over time, and may be particularly acute in offshore installations. For this reason, the gathering system operates in a constrained environment and modifications may be used to ensure handling requirements can be managed with continued production/injection as more nodes are added to the development of the asset. This aspect of the problem is also considered hereinafter.

Definition of Terms (Nomenclature)

For the purposes of the discussion hereinafter, the following variables and terms are used:

A (Bounded Area for New Well Location): a vicinity where a new node can be located, and within which an optimized location may be determined, e.g., to avoid surface and downhole collision with existing trajectories related to existing nodes. A computer-implemented automated tool, e.g., a field development planning tool such as the RapidPlan™ field development planning tool available from Schlumberger®, the assignee of the present application, may be used to optimize the location of the target of the node, in a reservoir, given surface location constraint(s). When optimizing for a node target in the reservoir, surface constraints may be significant.

b (Invariant Boundary Conditions): boundary conditions associated with $\Omega$ or $\Omega'$, which may include pressures, erosional velocity limits, rates, choke settings, etc. b' may represent revised boundary conditions as a result of adding new network(s) to a system (i.e., $\Omega'$).

B (Variable Boundary Conditions): variable boundary conditions associated with $\Omega'$, generally applied in fully coupled solutions and adjusted as new networks are added and come on-stream.

E(x,y,$\theta$) (Edge (Conduit) Topology Input Function): a function of co-ordinates (x, y) and azimuth, $\theta$, also used as an input to optimize F. E(x, y,$\theta$) may comprise any function affecting the cost or figure-of-merit for the edges (or conduits) connecting nodes. E(x, y,$\theta$)' represents a Revised Edge Topology Map as a result of adding new network(s) to the system.

F (Objective Function): generally a single-valued figure-of-merit that represents a goal of optimization, which may, in different embodiments may be minimized or maximized to represent an optimal solution. Non-limiting examples include maximum cumulative oil production (over a stated period), minimum cost, or other metrics.

K (Known Number of Source/Sink Nodes): a number of source/sink nodes in a network (or networks) to be optimized.

K' (Unknown Number of Source/Sink Nodes): as K (above), but representing an unknown number of nodes.

m (Single Manifold/Tie-in Point): a single known tie-point or manifold. If a network has multiple manifolds, then m is a subset of M.

M (Candidate Manifolds/Tie-in Points): a set of potential candidate manifolds (or network tie-points) that a new optimized network may be connected to. These manifolds are impacted by boundary conditions specified in b.

$M_{new}$ (New Manifold or Tie-Back Point(s)): a set of one (or more) new manifolds where new network(s) can be tied into. These may be located along an existing trunk line or may represent a completely new manifold location (linked to a new or existing asset sink).

N(x,y) (Node Topology Input Function): a function of any co-ordinate (x, y) used as an input to optimize F. N(x, y) may comprise practically any function affecting the cost or figure-of-merit for the nodes. Any single point on a map with co-ordinates (x, y) may be considered to have a value $n_{x,y}$. N(x, y)' represents a Revised Node Topology Map as a result of adding new network(s) to the system.

T Topology of New Optimal Network): a single, or multiple, optimal network topologies that satisfy the stated objective function, F.

X (Multiple (x,y) Location): a set of many (x, y) co-ordinates (e.g., in a vicinity A).

Y (Multiple Vicinities): a set of two (or more) vicinities, as defined by A.

$\Theta$ (Multiple Azimuths): a set of many possible $\theta$ azimuths (e.g., in a vicinity A).

$\Omega$ (Existing Network): represents the parameters related to the existing network (e.g., fluid properties, materials, pressure, equipment, etc.). $\Omega'$ represents revised parameters by adding new network(s).

Based upon these terms, a general expression for a single, or multiple, optimum network(s) may be considered to be:

$$F = \min/\max[f(x, y, N(x, y), E(x, y, \theta), A, M, \Omega, b, \ldots)], \qquad (1)$$

where f (.) is the function being evaluated. The "..." symbol may represent any other aspect that may be used for surface network optimization that may not have been captured by '$\Omega$'.

Topology Maps

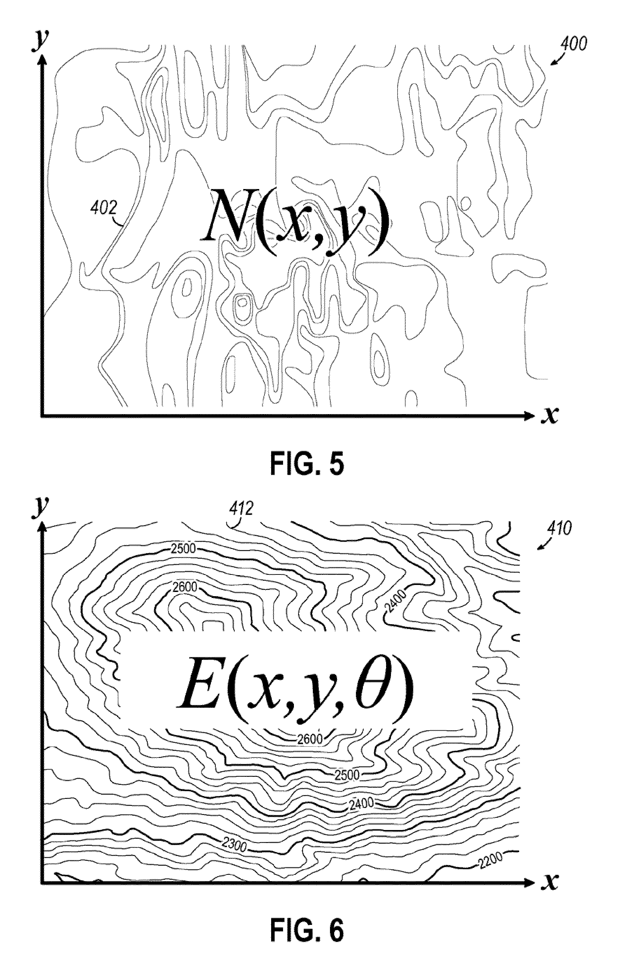

Now turning to Figs. 5 and 6, to enable network configuration/design (for example using, but not necessarily exclusively, graph theory) one or more generalized topology maps may be defined and used to provide a foundation for valuation (and thus optimization) of a stated objective function.

For example, a generalized topology for the nodes in a network (in x-y space) may be defined, e.g., as shown by node topology map 400 in Fig. 5. Map 400 may include contours 402 that represent a function N for a node defined by co-ordinates (x, y). For example, contours may represent cost, height, etc. Note that in some embodiments such a map may itself be the sum of several underlying maps, each representing different aspects of the topology (i.e., N(x, y)=$\Sigma_i g(x, y)_i$ where g(.) is practically any applicable underlying function). For convenience, and without loss of generality, only a single cumulative cost map is considered herein, though the invention is not so limited.

A node topology map may be defined by the following general function:

$$n_{x,y} = N(x, y), \qquad (2)$$

where $n_{x,y}$ is some value at co-ordinates (x, y) computed from the function N(x,y).

Assume, for example, that contours 402 represent construction cost (in dollars) of placing a node at co-ordinates (x, y). Such a 'cost map' will therefore reflect the cost of locating any node (or set of nodes) suggested by a network design optimization routine. However, it will be appreciated that a node topology map is not restricted to merely cost. Contours may comprise functions involving, for example, height, in situ geography, rock type, cost, local regulations, etc.

In addition, as shown in Fig. 6, an edges topology map 410 including contours 412 may be used to represent practically any function E for an edge traversing co-ordinates (x, y) with an azimuth θ. Once again, the contours, for example, may represent cost, constraints, etc., or some composite function that is affected by traversing any location defined by sets of coordinates and azimuth (x,y,θ).

An edges topology map may be defined by the following general function:

$$e_{x,y} = E(x, y, \theta), \qquad\qquad (3)$$

where $e_{x,y}$ is some value computed from the function E(x, y,θ).

Assume, for example, that the contours represent cost (in dollars) of traversing from one location (say, point "A") to another (say, point "B"). One may traverse along, over or meander through or around these contours. Irrespective of such a path, the cost of constructing any edge between two nodes in a new (or existing) network (from A to B) may be computed accordingly.

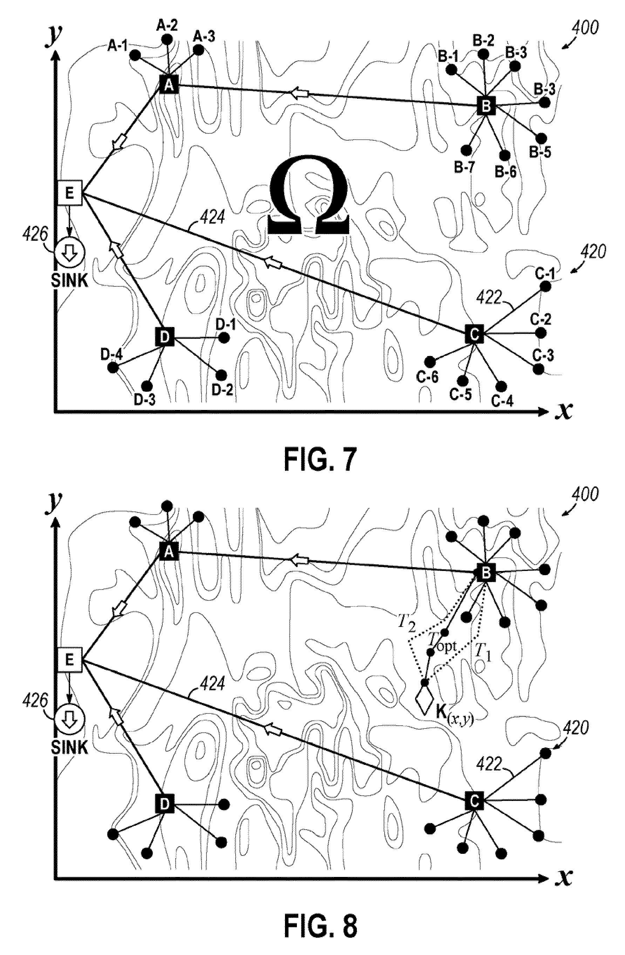

If a new network is to be constructed amidst an existing network (i.e., tied into one that already exists) the existing network may be defined using a global parameter set labeled "Ω". Fig. 7, for example, shows an existing network 420 and any associated properties (e.g., fluid properties, geometries, equipment, valves, wellhead safety valves, etc.) assembled under a single set, Ω (the super-set) of all parameters. In this figure, network 420 is superimposed on node topology map 400 of Fig. 5. Network 420 includes four main manifolds (labeled A, B, C & D). Manifold node "A" has 3 source nodes (production wells) connected to it (labeled A-1, A-2 & A-3). Manifold node "B" has 7 source nodes, manifold node "C" has 6 source nodes and manifold node "D" has 4 source nodes (production wells) connected to it, with each using similar notation as shown for manifold "A". Each source node is connected to its respective manifold node by an edge 422 (e.g., representing a conduit of some form), and the manifold nodes A-D are themselves connected, via long edges 424 (e.g., representing pipelines). The direction of flow is shown by the arrow on each long edge 424. A primary asset export manifold node "E" may be considered an asset gathering node and is connected to an export line (or asset sink) 426. 'Ω' represents the set of properties of this existing network, including, for example: fluid properties, equipment, pipes, valves and so on.

Automated surface network generation to extend an existing network in the herein-described environment is further described within the context of a number of cases that progressively add complexity to the process. Each of these cases is set forth separately below. It will be appreciated, however, that these cases are not exclusive, and the invention may be utilized in other contexts and scenarios, as will be apparent to one of ordinary skill in the art having the benefit of the instant disclosure.

Case 1: One new node at a known location connected to a known manifold node, m

Referring to Fig. 8, consider a first case of a single new source node, "K", located at known co-ordinates (x, y), to be connected to a known manifold node, m, in this case manifold node "B." Fig. 8 also shows two sub-optimal network connection "trials" (labeled $T_1$ and $T_2$) as well as a selected network topology, $T_{opt}$. The optimum topology, $T_{opt}$, of the new network connecting "K" to "B", in the presence of Ω that also satisfies given constraints, b, may be expressed as:

$$F = \min/\max[f(T|x, y, m, b, N(x, y), E(x, y, \theta), \Omega')]. \qquad\qquad (4)$$

In this case (and all the following cases), it may be assumed that the figure-of-merit to be optimized is cost, which is to be minimized. However, other objective functions such as maximum production potential, for example, may be accommodated by changing ('min' to 'max'). The fact that a new network has been added to the system means that the existing network has been modified in some way. This revised (updated) system may be denoted by Ω', which simply states that all new elements (those of the new network with possibly new fluids and other parameters) are now part of the network 420. Invariant network boundary conditions b may also be assumed; however, if the inclusion of a new network to the existing network results in changes to these boundary conditions, then such revisions may be denoted as b'.

Case 2: One new node, to be located at a location with a vicinity A, connected to a known manifold node, m

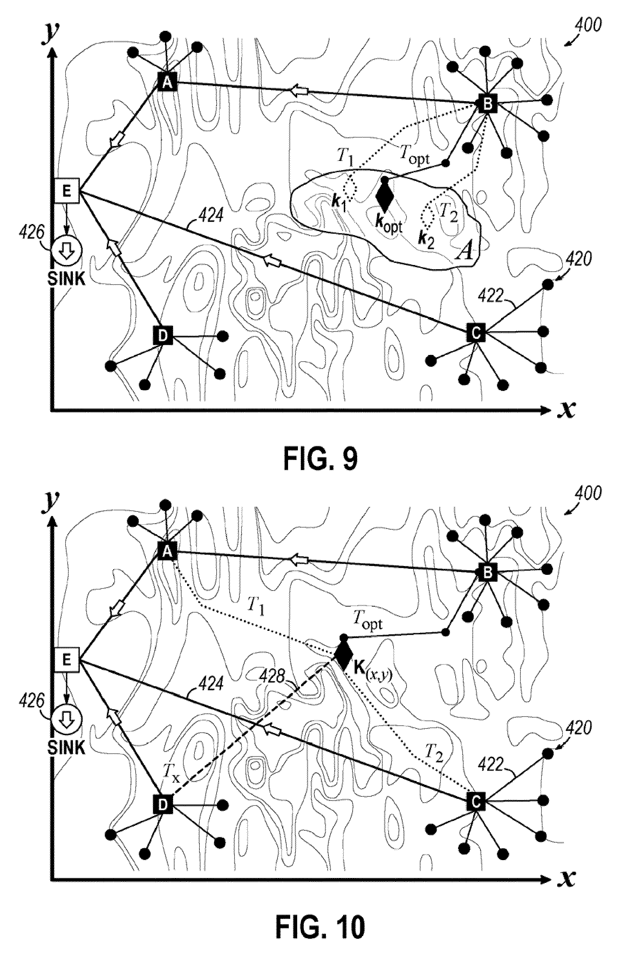

Now consider the case where a bounded vicinity A (in x-y space) where a new source node may be located is provided. Fig. 9 illustrates an example connection topology determined for a given manifold node m="B". Using a field development tool such as the aforementioned RapidPlan field development tool, one could try different source node locations (e.g., as represented by locations labeled $k_1$ and $k_2$). Connecting these (sub-optimal) locations are corresponding network topologies, here labeled $T_1$ and $T_2$. In this case, however, topologies $T_1$ and $T_2$ represent optimum topologies for the connecting network for sub-optimal nodes. In contrast, $T_{opt}$ illustrates a connection topology for an optimum node location, $k_{opt}$.

This problem can be expressed as follows:

$$F = \min/\max[f(T, x, y | A, m, b, N(x, y), E(x, y, \theta), \Omega')].  \qquad (5)$$

Case 3: One new node at a known location connected to an unknown manifold node, M

M is a set of candidate manifolds nodes (labeled A, B, C & D in Fig. 7, above). Node "K" (with a known fixed location) may be connected to any of these manifold nodes. Fig. 10 illustrates this scenario, which differs from Case 1 based upon the manifold m not being specified.

The optimal network topology for each manifold node is also shown as dashed lines (labeled $T_1$ and $T_2$) to manifold nodes "A" and "C", and with an optimum network topology, $T_{opt}$, shown coupled to manifold node "B". Note, however, edge 428 linking node K to manifold node "D". While manifold node "D" is itself a legitimate candidate node (i.e., one capable of accommodating the extra production capacity from source node K), it becomes effectively "unfeasible" as the network would need to cross (or bridge) an existing edge 424 between manifold nodes "C" to "E". This existing edge represents an obstacle. Such obstacles do not necessarily have to be existing parts of the network, they could be natural obstacles such as a river, for example. As such, it may be desirable in some embodiments for an optimizer to impose a harsh penalty (e.g., a high cost) in order for the network to cross the obstacle, therefore rendering it an unfeasible candidate. Such obstacles may also be defined as constraints (i.e., making manifold node "D" unfeasible and not part of the possible solution space.

In terms of an expression, this case may be stated mathematically as follows:

$$F = \min/\max[f(T, M | A, x, y, b, N(x, y), E(x, y, \theta), \Omega')].  \qquad (6)$$

Note that in this case, M is brought to the left-hand-side of the expression. In other words, it forms part of the unknown solution.

Case 4: One new node, to be located at a location in vicinity A, connected to an unknown manifold node, M

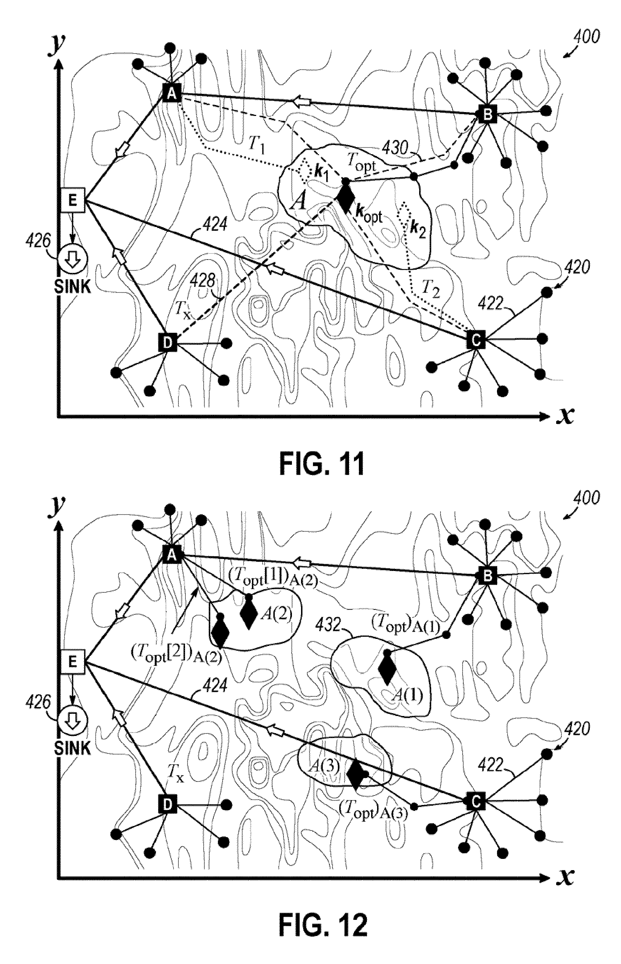

This case is effectively a composite of Cases 2 & 3 above, and is illustrated in Fig. 11. An assumption on invariant boundary conditions, b (to be revised later), may be retained. M is a set of candidate manifolds nodes (labeled A, B, C & D). Node K is now to be located somewhere in the vicinity labeled A. Optimum network topologies for non-optimal nodes are represented by dashed lines ($T_1$ for $k_1$ and $T_2$ for $k_2$) along with the optimum topology for the optimum node $k_{opt}$. Manifold node "D" is once again unfeasible due to the need to cross (bridge) a known obstacle (in this case, the existing edge connecting nodes "C" to "E"). Also annotated on this figure are dashed lines 430 illustrating sub-optimal network topologies from the optimal node location $k_{opt}$ linking manifold nodes A, B, & C. The solid line, labeled $T_{opt}$, is the optimal network topology for the optimal node location (which connects to manifold node "B").

Case 4 may be summarized as:

$$F = \min/\max[f(T, x, y, M | A, b, N(x, y), E(x, y, \theta), \Omega')].  \qquad (7)$$

Note that T, x, y and M are now on the left-hand-side of the function f (.) as unknowns.

Case 5: Many new nodes located in locations in vicinity A, connected to one or more manifold nodes, M

In the previous cases, x and y were stipulated as the coordinates for the node. For this case, however, there may be K possible nodes (all located within vicinity A), each with its own unique location. It may or may not be known the manifold nodes to which any one of these is to be connected. The number of possible nodes that may be necessary (for example, to deliver a specified production target) may also vary, hence K may not always be known in advance. This set of multiple x-y locations may be denoted as X. Thus, in equation form:

$$F = min/max[f(T, X, M, K | A, b, N(X), E(X, \Theta), \Omega')]. \qquad (8)$$

In this scenario, the concept of obstacle penalization becomes more problematic as succeeding networks must traverse a solution space that is populated with newly defined networks, while N(X) was previously fixed. In this case, as new networks come on stream, N(X) may be revised (updated), denoted by N(X)', to incorporate these new obstacles (new pipes) and topologies as they become present. In addition, the edge topology map may require updating and may be denoted by E(X,Θ)'. Ω' furthermore may also be continually updated as new networks are added/updated.

$$F = min/max[f(T, X, M, K | A, b, N(X)', E(X, \Theta)', \Omega')]. \qquad (9)$$

Case 6: Many new nodes, numerous locations, numerous manifold nodes, M

In this case, there no longer is a single vicinity (region) over which a field development planning tool is operating, but rather there may be multiple zones/regions over which K' nodes are to be located. These multiple vicinities (e.g., vicinity 432) may be denoted as Y. Fig. 12 summarizes this case, where each vicinity 432 in Y is a "development" location, each of which may include one or more nodes for which network optimization is to be performed. Let Y denote possible areas such that Y = {A(1),A(2),A(3)}. The optimum node location for each vicinity 432 is also shown along with its respective optimum connecting topologies. Note that two nodes could be found to be the optimum solution for vicinity A(2), hence the optimum corresponding topologies (as shown) are denoted as $(T_{opt}[1])_{A(2)}$ and $(T_{opt}[2])_{A(2)}$ where the [.] represents nodes "1" and "2" in that vicinity.

This more complex solution may be expressed as follows by:

$$F = min/max[f(T, X, M, K', Y | b, N(X)', E(X, \Theta)', \Omega')], \qquad (10)$$

where K' denotes an unspecified number of nodes and Y is the set of permissible areas (vicinities) where a node, or any number of nodes, may be placed.

Case 7: Fully coupled systems

To this point, a number of cases have been presented with the explicit assumption of invariant boundary conditions, b. However, it is known that as more nodes come on stream, possibly producing from different reservoir units, each with their own fluid types and various pressures, the boundary conditions will likely change. To account for this, fully coupled simulation solutions may be accommodated, where the true impact of those boundary condition changes may be fully and explicitly accounted for. If B is assigned to represent this variable boundary condition, then the expression for optimal network configuration in the presence of multiple manifold nodes, source and sink nodes, infill regions (vicinities), and existing and new networks may be stated in the most general terms as:

$$F = min/max[f(T, X, M, K', Y, B | N(X)', E(X, \Theta)', \Omega')]. \qquad (11)$$

Equation 11 thus represents the optimal solution to a fully coupled, variable boundary condition, multi-source node, multi-sink node, multi-manifold node (tie-in), multi-region (vicinity) problem.

Case 8: Fully coupled system with designated node 'clusters'

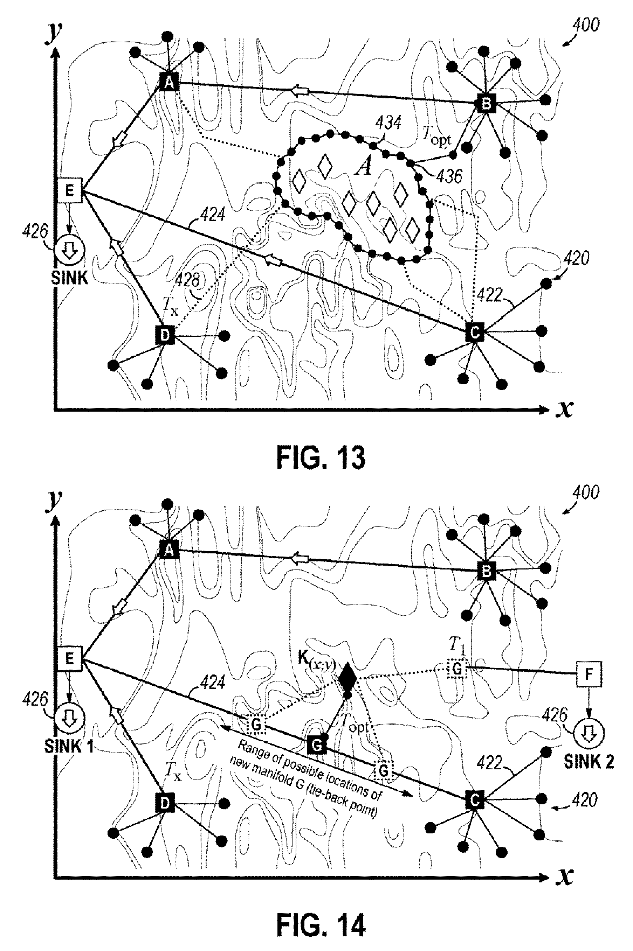

In the definition of the foregoing problems/equations (1)-(11), the complexity of the associated optimization problem increases significantly when many new nodes are to be located with permissible connections to many existing connection edges and manifold nodes. Thus, one manner of mitigating this computational complexity may be to group a number of nodes, intended in a certain locality, into 'clusters' defined by some closed boundary over which a fixed number of permissible connection nodes are given (defined as boundary manifold nodes). See, for example, the fixed number of nodes specified on the closed boundary of region 'A' in Fig. 13. As shown in this figure a cluster of nodes is shown with a known (and closed) boundary 434 comprising a fixed number of permissible connection manifold nodes, known as boundary nodes. The dotted lines illustrate several sub-optimal paths from certain boundary nodes to manifolds "A", "C" and "D". The optimal connecting edge $T_{opt}$ is shown extending between manifold node "B" and an optimal boundary manifold node 436. This procedure may reduce the computational complexity and solution time, especially when many clusters comprising many nodes are in contention.

The optimization problem in this case is therefore concerned with selecting the boundary node and a connection to a permissible node on the existing network so as to optimize the stipulated objective. This procedure has the benefit of reducing the number connections possible and speeding up the optimization solution. Without loss of generality, the mathematical definition in equation (11) may be applied with the understanding that the connections (X) may include the location of boundary nodes (or manifold nodes) on any number of clusters. In addition, the selected boundary nodes may be known or treated as variables in the problem. Note that each node designated in a particular cluster may be assumed to be tied back into one (or more) of these selected boundary manifold nodes. This simplifies the optimization problem, especially when many clusters (comprising many source/sink nodes) are in contention.

Case 9: Connecting node(s) to new manifold node(s) previously not defined in M

Fig. 14 next shows a single new (source) node $K_{(x,y)}$, but connected to a new manifold node, denoted here as "G". $T_{opt}$ represents the optimal network connecting $K_{(x,y)}$ to this new manifold node "G" that is tied into an existing edge (edge 424 connecting manifold nodes "C" to "E"). The utility of cutting and dividing edges in order to allow such tie-backs should therefore be apparent for some embodiments. The dashed lines show examples of trajectories of edges connecting $K_{(x,y)}$ to sub-optimal manifold nodes (labeled "G'") tied into edge "C" to "E". Note also that this class of optimization is generally not restricted to a tie-back to an existing edge, but may also be free to add a new manifold, shown here as manifold node **"F"** that has its own asset sink 426 labeled **"SINK 2."** This example applies to a single node **"K"** at known location; however, it will be appreciated that the concept can be applied to any of the preceding examples. The extra cost of adding a new asset sink may become practical because of the use of the node and edge topological maps described above.

This example may be expressed as:

$$F = \min/\max[f(T, x, y, M, M_{New}, |b, N(x,y)', E(x,y,\Theta)', \Omega')], \qquad (12)$$

where $M_{New}$ is a set of new manifold nodes, previously not present in M.

Case 10: Iteration for optimal system after adding new nodes and/or networks

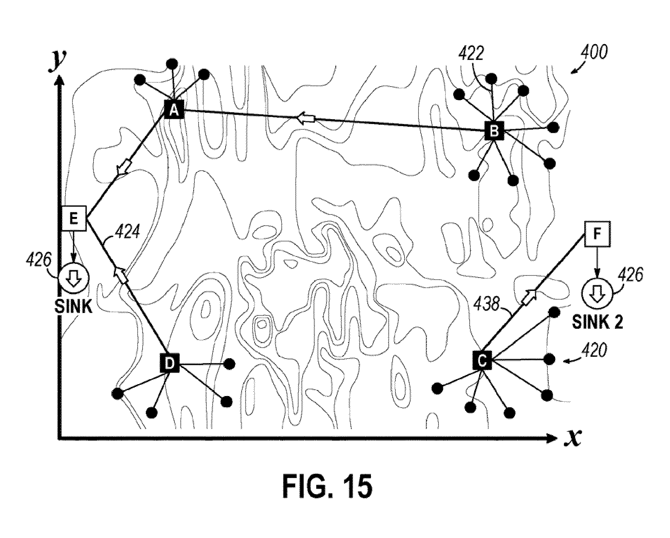

It may be deduced that by adding new nodes and edges (i.e., networks) to a surface network or system, the system has been changed. Previously, in Case 7, a problem class was established with variable boundary conditions as a result of adding new networks to the system. In this case, the presence of these new network(s) and/or the presence of new manifold nodes may result in either the existing network becoming sub-optimal and/or previously optimized networks becoming sub-optimal due to the addition of new nodes. Fig. 15 illustrates an example of the addition of a new manifold node **"F"** with associated asset sink node 426. The presence of **"F"** now means that the previous edge connecting manifold nodes **"C"** to **"E"** (e.g., as shown in Figs. 7-13) is sub-optimal and that a new edge 438 from **"C"** to **"F"** is a more optimal network configuration.

The mere presence of a new network or networks (e.g., the inclusion of new nodes and/or edges) in an existing system may disturb the system such that it may require iteration in optimization and some re-examination of the (previously) optimal networks. Consequently, in this case is may be desirable to iterate the network optimizer. Earlier system changes were defined previously as $\Omega \rightarrow \Omega'$ and considered in the optimal network design. For iteration purposes, with new (optimal) nodes and edges present (in $\Omega'$), an iteration may be performed such that $\Omega' \rightarrow \Omega''$. In other words, the network optimization may consider the revised infrastructure through $\Omega''$, with as many iterations as necessary or desired.

Therefore, in expression form (and taking the most unconstrained case), the problem may be expressed as follows:

$$F = \min/\max[f(T, X, M, K', Y, B|N(X)', E(X,\Theta)', \Omega'')]. \qquad (13)$$

Case Summary

The aforementioned cases present, in a somewhat sequential manner, a method for optimization of a surface network or surface networks in the presence of many variables that may impact their optimal design, e.g., cost, location, fluid properties, geography, existing infrastructure, obstacles, in-fill campaign or green-field development requirements, reservoirs, etc. Therefore, optimization in some embodiments may scale from a relatively simple single source/sink node, single (known) manifold node problem to multi-nodal, multi-manifold nodes (either existing or new), including possible fully coupled solutions. Case 10 above even considers the impact of the addition of new networks and possible new asset sink nodes on an existing system (both prior to new networks and also with new 'optimal' networks), meaning that an iterative optimization process may also be used in some embodiments to further optimize a network configuration. Case 8 also describes a mechanism to potentially accelerate computationally heavy optimization problems in some embodiments of the invention.

It will be appreciated, however, that details regarding specific solvers for implementing the various cases presented above may be dependent upon the problem type to be solved. Nonetheless, implementation of such details would be well within the abilities of one of ordinary skill in the art having the benefit of the instant disclosure, including for example, procedures to generate an edge (connection path) from a selected node location to a node on an existing network, simulation of production/injection from source/sink nodes, and evaluation of a figure-of-merit metric based on some predefined objective (e.g., production maximization while accounting for the costs incurred to develop the network connecting the new nodes). In addition, one of ordinary skill in the art so benefited would recognize the manner in which operating constraints may be defined and managed. For example, operating constraints concerning capacity handling limits, manifold node connection restrictions and physical (both natural and man-made) obstructions, amongst others, may be defined and/or managed, and thereafter utilized in connection with constraining optimization of a surface network model. For varying boundary conditions, network and reservoir balancing procedures may be used to converge the coupled systems, thereby allowing for back pressure effects to be included and permitting a more rigorous treatment of reservoir dynamics on the surface network model. While other computer-implemented tools may be utilized in connection with the techniques disclosed herein, it will be appreciated that various tools available from Schlumberger Ltd., e.g., the PipeSim, Petrel, Avocet-IAM, and RapidPlan tools and the SDR optimization library, may be used in some embodiments of the invention, and the utilization of such tools in connection with automated surface network generation will be apparent to one of ordinary skill in the art having the benefit of the instant disclosure.

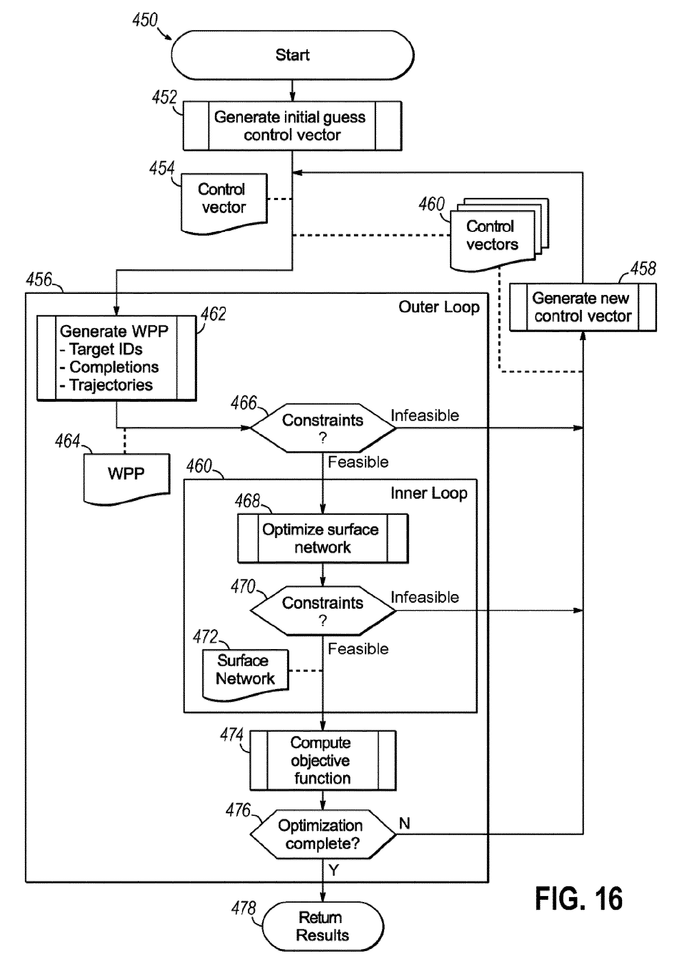

Now turning to Fig. 16, an example well placement planning workflow 450 in accordance with implementations of various technologies and techniques described herein is illustrated, to perform automated surface network generation in connection with well placement planning in the presence of a geological model of a reservoir. Workflow 450 may utilize a framework that automatically generates an optimal Well Placement Plan (WPP) based on a reservoir model, and including an optimal surface network incorporated within the WPP. Prior to discussing workflow 450, however, a brief introduction to an example optimization framework for use therewith is provided.

In particular, embodiments consistent with the invention may be used to facilitate well placement planning and automated surface network generation through the use of an optimization framework that applies a constrained optimization approach to generate an optimal well placement plan based upon an objective function as described above.

In general, well placement planning is an optimization problem that may be framed as a general nonlinear constrained optimization problem, e.g., by minimizing an objective function F subject to:

$$l_i \leq x_i \leq u_i \qquad \text{for } i=1,\ldots,n \qquad (14)$$

$$g_j(x) \leq 0 \qquad \text{for } j=1,\ldots,q \qquad (15)$$

$$h_j(x) \leq 0 \qquad \text{for } j=1,\ldots,m \qquad (16)$$

where

$x = \{x_1, \ldots, x_n\} \subset \mathbb{R}^n$ is a set of n control variables over which to optimize,

$F: \mathbb{R}^n \to \mathbb{R}$ is the objective function,

l, u the lower and upper bounds respectively,

$g: \mathbb{R}^n \rightarrow \mathbb{R}^q$    the inequality constraints, and

$h: \mathbb{R}^n \rightarrow \mathbb{R}^m$    the inequality constraints.

The constraint functions (g, h) may be linear or non-linear with respect to the control variables.

A number of approaches exist for discovering the optimal set of control variables x, also referred to herein as a control vector that optimizes the objective function. For example, in some embodiments, well placement may be treated as an integer or a mixed integer problem in which all or some of the control variables assume integer values, while in other embodiments, some control variables may assume continuous real values that cannot be treated as an integer or mixed integer problem.

In addition to the control variables being continuous, well placement optimization problems generally have computationally complex objective and constraint functions for which simple functional forms are generally not available. As such, this problem generally will also not have derivatives of the objective and constraint functions available, because the analytical form generally cannot be obtained and the numerical form may be too noisy to be useful.

In embodiments consistent with the invention, on the other hand, a derivative free optimization approach, e.g., a nonlinear downhill simplex pattern search algorithm or a stochastic optimization algorithm, may be used. Other optimization techniques that may be used in the embodiments discussed herein include Genetic Algorithms (GA), Simulated Annealing (SA), Branch and Bound (B&B), Covariance Matrix Adaptation-Evolution Strategy (CMA-ES), Particle Swarm Optimization (PSO), Spontaneous Perturbation Stochastic Approximation (SPSA), Retrospective Optimization using Hooke Jeeves search (ROHJ), Nelder-Mead downhill Simplex (N-M), or Generalized Reduced Gradient (GRG) Genetic, among others. The embodiments discussed hereinafter will focus on a nonlinear downhill simplex algorithm because of its simplicity and robustness across a wide spectrum of domains; however, it will be appreciated by those of ordinary skill in the art having the benefit of the instant disclosure that other optimization algorithms or techniques may be used in other embodiments without departing from the spirit and scope of the invention.

With any of the aforementioned optimization algorithms, an optimization engine generally proposes a control vector, and the objective function is evaluated. The algorithm then proposes a new "trial" of the control vector using information from the results of previous trials, with the goal of selecting a control vector that improves the value of the objective function. The optimization generally terminates when the maximum number of trials has been evaluated or a desired accuracy of the objective function and control vector values has been reached.

In optimization problems of this nature, the question of the global versus local optimum may arise. In global optimization, the true global solution to the optimization problem is found. However, global optimization is only suitable for problems with a small number of variables. When optimizing a problem such as that described herein, it may be difficult to ascertain whether a global optimum has been found. However, it has been found that there are a number of safeguards available to ensure an answer, if not provably optimal, is not an unreasonable local optimum. The safeguards may include, for example, generating a good initial guess so that the downhill simplex engine has a good starting point, and when an optimum solution has been found, the optimal control vector can be used as an initial guess for a repeat optimization, with such nested optimizations optionally repeated until no substantial improvement in the optimum is found.

The general downhill simplex method is an unconstrained optimization technique in which the elements of the control vector x are unbounded. However, well placement optimization has been found to be a highly constrained problem in which the control vector elements are not only bounded as shown in equation (14) but also subjected to linear and non-linear constraints as shown in equations (15) and (16).

To extend the nonlinear downhill simplex method to support constrained optimization a sequential lexicographic approach may be used, where the original problem is reformulated into another minimization problem in which the original objective function f(x) is minimized subject to $\Phi(x) \leq 0$, where the constraint violation function $\Phi(x)$ is strictly positive for infeasible control vectors and less than or equal to zero for feasible ones, that is:

$$\Phi(x) > 0 \qquad \text{if } x \notin \mathbb{F}$$

$$\Phi(x) \leq 0 \qquad \text{if } x \in \mathbb{F}$$

where
IF is the feasible region.

In this transformed problem, control vectors may be compared using the lexicographic order comparison operator ($<_{CL}$) rather than simple comparison of the objective function values, that is:

$$(f_1, \Phi_1) <_{CL} (f_2, \Phi_2) \Leftrightarrow \begin{cases} \text{if } (x_1 \notin \mathbb{F} \lor x_2 \notin \mathbb{F}) & : & \Phi_1 < \Phi_2 \\ \text{else} & & f_1 < f_2 \end{cases}$$

This approach may be further refined in the hereinafter-described embodiments to distinguish between inexpensive and expensive constraints, particularly where an objective function evaluation is computationally expensive. Inexpensive constraints may be considered to be constraints for which the feasibility can be determined before the objective function is evaluated or otherwise without using results of the objective function in the determinations, while expensive constraints may be considered to be constraints determined after the objective function is evaluated or otherwise using results of the objective function in the determinations. Reformulating the problem in this manner allows for a reduction in the number of evaluations of a relatively expensive objective function, and a new lexicographic sequential order comparison operator ($<_{SL}$) may be defined as follows:

$$(f_1, \Phi_{l1}, \Phi_{nI1}, \Phi_{nE1}) <_{SL} (f_2, \Phi_{l2}, \Phi_{nI2}, \Phi_{nE2}) \Leftrightarrow$$

$$\begin{cases} \text{if} & (x_1 \notin \mathbb{F}_l \lor x_2 \notin \mathbb{F}_l) & : & \Phi_{l1} < \Phi_{l2} \\ \text{else if} & (x_1 \notin \mathbb{F}_{nI} \lor x_2 \notin \mathbb{F}_{nI}) & : & \Phi_{nI1} < \Phi_{nI2} \\ \text{else if} & (x_1 \notin \mathbb{F}_{nE} \lor x_2 \notin \mathbb{F}_{nE}) & : & \Phi_{nE1} < \Phi_{nE2} \\ \text{else} & & & f_1 < f_2 \end{cases}$$

Put another way, when an optimization engine compares two control vectors $x_1$ and $x_2$, feasibility with respect to the linear constraints $\mathbb{F}_l$ may first be determined. If either vector is infeasible then the vector with the lower constraint violation function ($\Phi$) is determined to be better, and no further comparisons may be made. This comparison may then be repeated but with respect to non-linear inexpensive constraints $\mathbb{F}_{nI}$, and thereafter if necessary with respect to non-linear expensive constraints $\mathbb{F}_{nE}$. If both vectors are determined to be feasible with respect to all of these constraints then the objective function values may be compared directly.

Now returning to Fig. 16, workflow 450 may be used to automate the process of placing new wells in a reservoir and/or sidetracking or recompleting existing wells, and automatically generating or updating a surface network in connection therewith, and does so using constraint-based optimization techniques. As will become more apparent below, optimization of an WPP using one embodiment of workflow 450 may utilize a constrained downhill simplex approach. During a trial, WPP's proposed by an optimization engine in earlier trials may be extrapolated to propose a new WPP (which, within this context of the invention, is also considered to include an automatically-generated surface network. A proposed WPP may be evaluated for satisfying a range of geometric, operational, contractual, and legal constraints on the surface, and in the overburden and reservoir. Collision and hazard avoidance computation may also use a geocomputation topology approach.

Specifically, as will be discussed in greater detail below, workflow 450 is dominated by a first, outer loop that generally involves the creation of a control vector by an optimization engine, the translation of this control vector into an WPP, the feasibility constraints analysis of that WPP, and the evaluation of the objective function for the WPP. A second, inner loop within the outer loop generates and/or optimizes a surface network for the candidate WPP. A single pass through the outer loop is termed a "trial", and this sequence of steps is termed a trial processing operation or element. The optimization engine, in this case the constrained downhill simplex discussed previously, then proposes a new control vector with the intention of discovering an optimal control vector. The optimization loop is then complete when one or more termination conditions is satisfied.

Workflow 450 may be implemented, for example, at least in part within petro-technical module 32 of Fig. 1, which may be implemented as, or otherwise access an optimization engine. Module 32 may also access one or more reservoir simulators (e.g., resident in E&P platform 34) for use in accessing one or more reservoir models. It will be appreciated by those of ordinary skill in the art having the benefit of the instant disclosure that some operations in workflow 450 may be combined, split, reordered, omitted, and/or supplemented with other techniques known in the art, and therefore, the invention is not limited to the particular workflow illustrated in Fig. 16.

Workflow 450 begins in block 452 by generating an initial guess control vector 454, which is then processed by a trial processing element 456, which upon completion of a trial, passes control to block 458 to generate another control vector 454. Control vectors and their associated trial results, including feasibility or infeasibility with respect to various constraints and the magnitudes of such feasibility/infeasibility, may also be maintained in a database or other data storage as illustrated at 460.

With respect to creation of a control vector in blocks 452 and 458, a control vector may be implemented as a vector of control variables, that is:

$$\mathrm{x} = \{\mathrm{x}_1, \dots, \mathrm{x}_n\} \subset \mathbb{R}^n$$

where each control variable assumes a value in the range:

$$0 \leq \mathrm{x}_i \leq 1.$$

The optimization engine in general may be unaware of the domain and physical meaning of each control variable. It is, however, one role of the trial processing element 456 of the workflow to analyze the control vector, generate a WPP and associated surface network, and inform the optimization engine of the feasibility and objective function values.

To generate an "initial guess" control vector in block 452, random numbers may be assigned in some embodiments, although in some instances, doing so may be inefficient as generally some knowledge of feasible and favorable values for at least some of the control variables will be known at the outset. In other embodiments, however, an initial guess control vector may be generated from an initial WPP from candidate target and platform tie point locations, or existing well and/or surface network components, in an operation that is effectively the inverse of generating a WPP from a control vector (which is performed in block 462, discussed below).

Targets for the initial control vector may be selected with criteria under a user's control. For example, it may be favorable to use targets near the crest of anticlines, or focus on regions with the maximum productivity index, or minimum water saturation. Other manners of generating an initial control vector will be appreciated by one of ordinary skill in the art having the benefit of the instant disclosure.

Next, turning to trial processing element 456, a trial is initiated for a control vector by creating a candidate WPP 464, as illustrated by block 462, which may also be referred to as translating the control vector into a candidate WPP. In this operation, target identification, trajectory creation and completion creation are performed for one or more wells based upon the control variables in the control vector to generate a WPP 464.

Once WPP 464 is generated in block 462, block 466 then performs an evaluation of the WPP against one or more constraints. In response to a well placement plan being determined to be infeasible based upon any constraint, block 466 terminates the trial for the current candidate control vector and returns control to block 458 to generate a new control vector.

If, however, the WPP is still determined to be feasible after performing feasibility evaluation against the constraints, block 466 passes control to an inner loop 460 to generate and/or optimize a surface network for the WPP, e.g., in any of the manners discussed above. Specifically, block 468 is executed to generate or optimize a surface network for the WPP, and once the surface network is optimized and/or generated, relevant constraints for the surface network are checked in block 470. In response to the optimized surface network being determined to be infeasible based upon any constraint, block 470 terminates the trial for the current candidate control vector and returns control to block 458 to generate a new control vector.

If, however, the optimized surface network (represented at 472) is determined to be feasible after performing feasibility evaluation against the constraint, block 470 passes control to block 474 to compute the objective function. It will be appreciated that optimization conventionally seeks to discover the feasible control vector yielding the minimum objective function value. In well placement planning, generally the desire is to maximize an objective function value. As such, in the illustrated embodiment, the computed value is negated before returning the value to the optimization engine.

In general, different workflows have different objectives, and therefore different objective functions may be used in different embodiments. For example, one objective may be to simply maximize recovery, in which case capital and operating costs along with oil or gas price may be ignored. This may also be the case if the objective is to maintain a plateau production rate. A more complete financial objective function may be used in some embodiments to calculate net present value (NPV) in which a forecast recovery, a commodity price, and the costs are considered along with a discount factor. Other objective functions that may be used include, for example, fiscal parameters such as return on investment (ROI) and profitability index.

Costs may be separated into capital and operating expenses. Capital expenses may include drilling, and surface facility, drilling, well, and completion construction. Operating expenses may include personnel, injection, production and treatment costs. Generally, the one component that adds value to the objective function is the oil or gas recovered from the reservoir, and everything else is cost. While a user may provide an estimate of a forecast commodity price, the production forecast itself generally is computed.

Once the objective function is computed, block 474 passes control to block 476 to determine whether the optimization is complete. If not, control passes to block 458 to generate another control vector. If so, control passes to block 478 to terminate the workflow and return results to the user.

Trial processing element 456 may therefore be repeated by the optimization engine until an optimal solution is discovered, or otherwise until another termination condition is met. In addition, as illustrated by block 460, optimization engine uses information garnered from control vectors, both infeasible and feasible, to extrapolate new control vectors from past trials. In addition, when the termination condition is met, feasible control vectors are reported back as results to the user, representing the viable WPP's determined from the workflow.

Block 476 may terminate workflow 450 in response to different termination conditions. For example, in one embodiment, a termination condition may be based on a determination that a maximum specified number of trials has been completed. In another embodiment, a termination condition may be based on achieving an objective function value that ceases to improve with successive trials within a specified accuracy, or put another way, a determination that improvement in the objective function has stalled (e.g., insufficient improvement has occurred over a most recent set of trials as prescribed by a tolerance). In other embodiments, a combination of determinations may be made, e.g., to terminate after the objective function does not improve more than X% over the last Y trials, but in any event never exceed Z total trials.

Embodiments consistent with the invention may also optimize in the presence of uncertainty. During uncertain optimization, an optimal control vector is being sought when the underlying model is uncertain. Under such conditions, the overall optimization workflow may remain the same, and function in essentially the same manner as illustrated in Fig. 5 as with deterministic optimization. However, for uncertain optimization, the value of the objective function being minimized may be considered to be a function of the uncertainty distribution in the objective function value. For example, the objective function value may have statistical moments such as mean ($\mu$) and variance ($\sigma^2$). The optimization engine may attempt to maximize a single value, which is now a function of these statistical moments. This function may be referred to as a "utility function". One utility function that may be used for this type of problem is defined as follows:

$$f_\lambda = \mu - \lambda\sigma$$

where $\mu$ and $\sigma$ are respectively the mean and standard deviation of the objective function value resulting from the uncertain model, $\lambda$ is the risk aversion factor, and $f_\lambda$ is the risk corrected objective function value. Optimization then involves maximizing $f_\lambda$.

The risk aversion factor ($\lambda$) may be a user-defined preference, and may be roughly considered equivalent to a confidence level. If, for a given control vector the uncertain objective function value were to be normally distributed this would be precisely true. For example, if $\lambda = 0$ there would be a 50% probability that the objective function value $f_0$ would be greater than the mean $\mu$, so an optimum median (50% confidence level) would be obtained by maximizing $f_0$. If $\lambda = 1$, there would be an 84% probability that the realized objective function value would be greater than $f_1$. Therefore, it can be seen that a higher value for $\lambda$ generally implies a more conservative decision.

While particular embodiments have been described, it is not intended that the invention be limited thereto, as it is intended that the invention be as broad in scope as the art will allow and that the specification be read likewise. It will therefore be appreciated by those skilled in the art that yet other modifications could be made without deviating from its spirit and scope as claimed.

**Claims**

1. A method for generating a surface network for a well placement plan, the method comprising:

   generating a control vector comprising a plurality of control variables over which to optimize;
   generating a candidate surface network from the control vector; and
   computing a result for an objective function for the candidate surface network, including computing the result for the objective function based upon at least one geographical cost function and at least one boundary condition.

2. The method of claim 1, further comprising:

   performing a first feasibility evaluation for the candidate surface network against one or more constraints;
   in response to determining an infeasibility of the candidate surface network from the first feasibility evaluation, bypassing computing the result for the objective function;

translating the control vector to a candidate well placement plan, wherein generating the candidate surface network includes generating the candidate surface network for the candidate well placement plan;

performing a second feasibility evaluation for the candidate well placement plan against one or more constraints;

in response to determining an infeasibility of the candidate well placement plan from the second feasibility evaluation, bypassing generating the candidate surface network and computing the result for the objective function; and

in response to determining a feasibility of the candidate well placement plan from the second feasibility evaluation, and determining a feasibility of the candidate surface network from the first feasibility evaluation, determining that the candidate well placement plan is a feasible well placement plan.

3. The method of claim 1 or 2, wherein the control vector comprises an initial control vector, and wherein the method further comprises generating the initial control vector by translating an initial well placement plan to the initial control vector.

4. The method of any of the preceding claims, further comprising, for each of a plurality of control vectors, performing a trial processing operation associated therewith, wherein each trial processing operation comprises generating the associated control vector, generating an associated candidate surface network from the associated control vector, and computing a result for the objective function for the associated candidate surface network.

5. The method of claim 4, further comprising, generating at least one of the plurality of control vectors by extrapolating from a prior control vector based at least in part on a feasibility evaluation performed during a trial processing operation for the prior control vector.

6. The method of any of the preceding claims, wherein the surface network includes at least one node and at least one edge coupled thereto.

7. The method of claim 6, wherein the at least one node includes one or more of a sink node, a source node or a manifold node.

8. The method of claim 6, wherein the surface network is tied-back to a second, existing surface network.

9. The method of claim 6, wherein the edge includes at least one characteristic, the at least one characteristic including one or more of an inlet pressure, an outlet pressure, a uniform cross-sectional area, an internal roughness, a maximum flowing capacity, or a length.

10. The method of any of the preceding claims, wherein the at least one geographical cost function is based on one or more of a node topology map or an edges topology map, wherein the node topology map expresses cost as function of node location, and wherein the edges topology map expresses cost as a function of one or more of edge traversal location or edge traversal orientation.

11. The method of any of the preceding claims, wherein the at least one boundary condition includes one or more of a pressure, a maximum flow rate, an erosional velocity, fluid composition, a network topology, a physical constraint, a natural obstacle, or a man-made obstacle.

12. The method of any of the preceding claims, wherein generating the candidate surface network includes one or more of connecting a new node at a known location to a known manifold node, connecting a new node at a location in a vicinity to a known manifold node, connecting a new node at a known location to an unknown manifold node, connecting a new node at a location in a vicinity to an unknown manifold node, connecting one or more new nodes at locations in a vicinity to one or more manifold nodes, connecting one or more new nodes to one or more manifold nodes, adding one or more new manifold nodes.

13. The method of any of the preceding claims, wherein generating the candidate surface network includes grouping multiple nodes in a cluster to reduce computational complexity.

14. An apparatus, comprising:

at least one processing unit; and
program code configured upon execution by the at least one processing unit to generate a surface network for a well placement plan by performing the method of any of the preceding claims.

**15.** A program product, comprising:

a computer readable medium; and
program code stored on the computer readable medium and configured upon execution by at least one processing unit to generate a surface network for a well placement plan by performing the method of any of the preceding claims.

**FIG. 1**

FIG. 2A

FIG. 2B

FIG. 2C

FIG. 2D

FIG. 3

FIG. 4

**FIG. 5**

**FIG. 6**

FIG. 7

FIG. 8

FIG. 9

FIG. 10

**FIG. 11**

**FIG. 12**

**FIG. 13**

**FIG. 14**

FIG. 15

FIG. 16